# EUROPÄISCHE PATENTSCHRIFT

(11) **EP 0 766 324 B1**
(45) Veröffentlichungstag und Bekanntmachung des Hinweises auf die Patenterteilung: **24.02.1999**
(21) Anmeldenummer: 96114167.8
(22) Anmeldetag: 04.09.1996
(51) Int. Cl.: H01L 33/00, H01L 29/06, H01L 21/78

(54) **Halbleiterbauelement und Herstellverfahren**
Semiconductor device and method of fabrication
Dispositif semi-conducteur et méthode de fabrication

(30) Priorität: 29.09.1995 DE 19536438
(43) Veröffentlichungstag der Anmeldung: 02.04.1997
(73) Patentinhaber: SIEMENS AKTIENGESELLSCHAFT, 80333 München (DE)
(72) Erfinder: Jakowetz, Wolf, Dr., 85591 Vaterstetten (DE); Fischer, Helmut, 93059 Regensburg (DE)

(56) Entgegenhaltungen:
- DE-A- 4 113 969
- DE-A- 4 305 296
- GB-A- 985 450
- GB-A- 1 471 116

## Beschreibung

Die Erfindung bezieht sich auf ein Halbleiterbauelement mit einem Halbleiterkörper, der eine Vorderseite, eine Rückseite und mindestens eine gewölbte Seitenfläche aufweist.

Solche Halbleiterbauelemente sind Stand der Technik und in DE-A-43 05 296 offenbart. Figur 3 zeigt beispielsweise eine schematische Darstellung eines Querschnitts durch einen Halbleiterkörper 12 mit Mesastruktur. Derartige Halbleiterkörper 12 werden beispielsweise bei Lumineszenzdioden eingesetzt. Das charakteristische Merkmal der Mesastruktur sind die gekrümmten Seitenflächen 15, die einerseits an die Vorderseite 28 und andererseits an die ebenen Seitenflächen 14 angrenzen.

Bei Lumineszenzdioden bewirken derart geformte und für die von der Lumineszenzdiode erzeugte Strahlung durchlässige Halbleiterkörper 12 eine gegenüber Lumineszenzdioden mit quaderförmigem Halbleiterkörper verbesserte Auskoppelung des in der Lumineszenzdiode erzeugten Lichtes und damit einen erhöhten externen Quantenwirkungsgrad (= Zahl der die Lumineszendiode pro Zeiteinheit verlassenden Photonen/Zahl der pro Zeiteinheit durch die Lumineszenzdiode transportierten Ladungen). Dies beruht darauf, daß im Vergleich zu einem quaderförmigen Halbleiterkörper bei dem oben beschreibenen Halbleiterkörper 12 wesentlich mehr des vom pn-Übergang 17 des Halbleiterkörpers 12 in Richtung der Rückseite 18 abgestrahlten und dort reflektierten Lichtes mit einem Winkel auf die Oberfläche des Halbleiterkörpers 12 trifft, der kleiner als der Grenzwinkel der Totalreflexion ist. Die Reflexions- und Absorptionsverluste im Halbleiterkörper werden dadurch deutlich verringert.

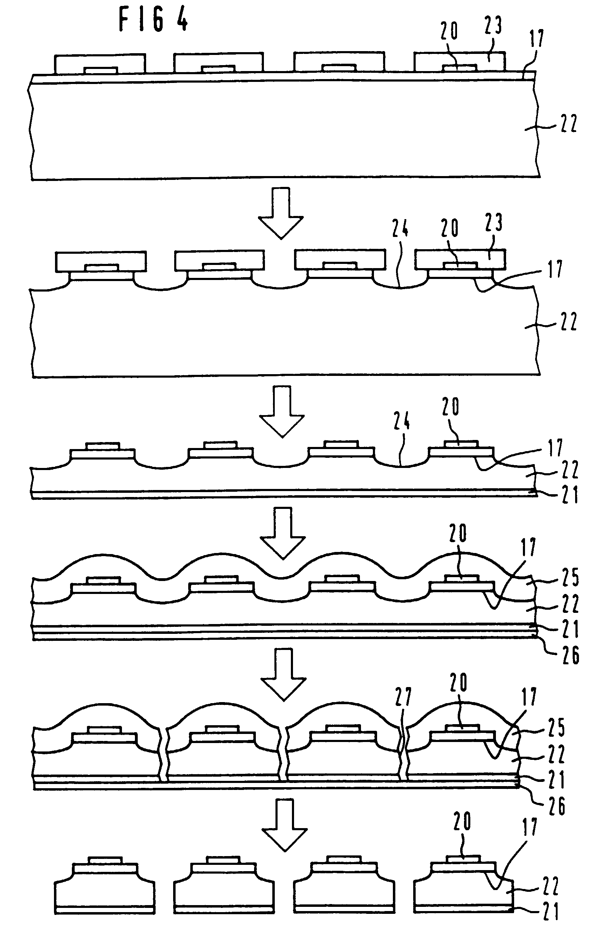

Ein Verfahren zur Herstellung eines Halbleiterkörpers 12 mit der oben beschriebenen Geometrie ist in Figur 4 schematisch dargestellt. Auf die Vorderseite einer Halbleiterscheibe 22 mit pn-Übergang 17 werden zunächst Kontaktmetallisierungen 20 und anschließend eine Mehrzahl von Ätzmasken 23 aufgebracht. Als nächstes werden mit einem geeigneten Ätzmittel eine Mehrzahl von Mesa-Gräben 24 in die Halbleiterscheibe 22 isotrop eingeätzt. Für eine Halbleiterscheibe 22, die aus GaAs und/oder GaAlAs besteht, eignet sich als Ätzmittel beispielsweise eine H₂SO₄/H₂O₂/H₂-Lösung (Mischungsverhältnis 3:1:1). Danach werden die Ätzmasken 23 entfernt, die Halbleiterscheibe 22 auf ihre Enddicke gedünnnt und eine Kontaktmetallisierung 21 auf die Rückseite der Halbleiterscheibe 22 aufgebracht. Im Anschluß daran werden die Oberfläche der Halbleiterscheibe 22 und die Kontaktmetallisierungen 20 mit einer Schutzschicht 25, beispielsweise Fotolack, Siliziumoxid oder Siliziumnitrid, abgedeckt. Als nächstes wird die Halbleiterscheibe 22 auf einem Träger 26, beispielsweise eine Kunststoff-Klebefolie, befestigt und anschließend beispielsweise durch Sägen in Chips vereinzelt. Nach dem Vereinzeln erfolgt ein weiterer Ätzschritt, das sogenannte Chipflankenätzen. Bei diesem Ätzprozeß wird das bei der Vereinzelung der Halbleiterscheibe 22 beschädigte Halbleitermaterial an den Schnittflächen 27 beseitigt. Als letzter Schritt werden die Chips vom Träger 26 abgetrennt.

Bei dem oben beschriebenen Herstellungsverfahren für Halbleiterkörper 12 mit Mesastruktur ist die Bruchgefahr für die Halbleiterscheibe 22 beim Sägen äußerst groß, da die Scheibendicke in den Mesagräben 24 sehr gering ist.

Außerdem ist bei Halbleiterkörpern für Lumineszenzdioden die Lichtauskoppelung aus dem oben beschriebenen Halbleiterkörper 12 gegenüber der Lichtauskoppelung aus einem quaderförmigen Halbleiterkörper zwar deutlich erhöht, der externe Quantenwirkungsgrad einer Lumineszenzdiode mit einem derart geformten Halbleiterkörper 12 ist jedoch nach wie vor sehr gering. Ein großer Teil des vom pn-Übergang 17 in Richtung der Rückseite 18 ausgestrahlten und dort reflektierten Lichtes trifft nämlich immer noch in einem Winkel auf die Oberfläche des Halbleiterkörpers 12, der größer als der Grenzwinkel der Totalreflexion ist. Dieses Licht wird daher erneut ins Innere des Halbleiterkörpers 12 reflektiert.

Der Erfindung liegt die Aufgabe zugrunde, einen Halbleiterkörper der eingangs genannten Art so zu verbessern, daß dessen Herstellungsverfahren vereinfacht ist, so daß insbesondere die Bruchgefahr der Halbleiterscheibe beim Sägen verringert ist.

Ein weiteres Ziel ist gleichzeitig, bei Halbleiterkörpern für Lumineszenzdioden die Lichtauskoppelung zu verbessern.

Diese Aufgabe wird dadurch gelöst, daß die gewölbte Seitenfläche von außen betrachtet benachbart der Rückseite konvex ist und benachbart der Oberfläche konkav ist, und daß die Fläche der Rückseite größer als die Fläche der Vorderseite ist.

Weiterbildungen der Erfindung sind Gegenstand der Unteransprüche 2 bis 7. Ein bevorzugtes Verfahren zur Herstellung des erfindungsgemäßen Halbleiterbauelementes ist Gegenstand der Ansprüche 8 und 9.

Bei einer vorteilhaften Weiterbildung des erfindungsgemäßen Halbleiterbauelements ist die gewölbte Seitenfläche bis zu einer ersten Dicke des Halbleiterkörpers konvex und die erste Dicke größer als die halbe Gesamtdicke des Halbleiterkörpers. Insbesondere bei lichtemittierenden Halbleiterkörpern ist dadurch vorteilhafterweise eine deutliche Verbesserung der Lichtauskoppelung erzielt, da der Halbleiterkörper sehr stark einer Kugelkalotte gleicht.

Bei einer bevorzugten Ausführungsform des erfindungsgemäßen Halbleiterbauelements ist auf den Halbleiterkörper eine Kunststoffumhüllung aufgebracht.

Bei einem bevorzugten Verfahren zum Herstellen von mindestens zwei erfindungsgemäßen Halbleiterbauelementen wird eine auf ein Trägermittel aufgebrachte vorgefertigte Halbleiterscheibe nach dem Aufbringen von mindestens zwei voneinander getrennten Ätzmasken auf die dem Trägermittel gegenüberliegende Seite der Halbleiterscheibe in mindestens zwei Teile zertrennt, werden nachfolgend die noch auf dem Trägermittel befestigten Teile isotrop geätzt, derart, daß eine Unterätzung der Ätzmasken entsteht und werden anschließend die Teile zu Halbleiterbauelementen weiterverarbeitet.

Ein besonders bevorzugtes Verfahren weist folgende Schritte auf:
- Herstellen einer Halbleiterscheibe,
- Aufbringen von mindestens zwei Vorderseitenkontakten entsprechend einem vorgegebenen Raster auf die Halbleiterscheibe,
- Aufbringen von mindestens einem Rückseitenkontakt auf die Halbleiterscheibe,
- Aufbringen von mindestens zwei voneinander getrennter Ätzmasken, derart, daß die Vorderseitenkontakte und ein Teil der Vorderseite der Halbleiterscheibe abgedeckt sind,
- Befestigen der Halbleiterscheibe auf einem Trägermittel,
- Durchtrennen der Halbleiterscheibe zwischen den Ätzmasken in Chips, derart, daß die Chips auf dem Trägermittel in ihrer vorherigen Anordnung verbleiben,
- isotropes Ätzen der Chips, derart, daß die Ätzmasken unterätzt werden,
- Entfernen der Ätzmasken,
- Ablösen der Chips vom Träger,
- Weiterverarbeitung der Chips zu Halbleiterbauelementen.

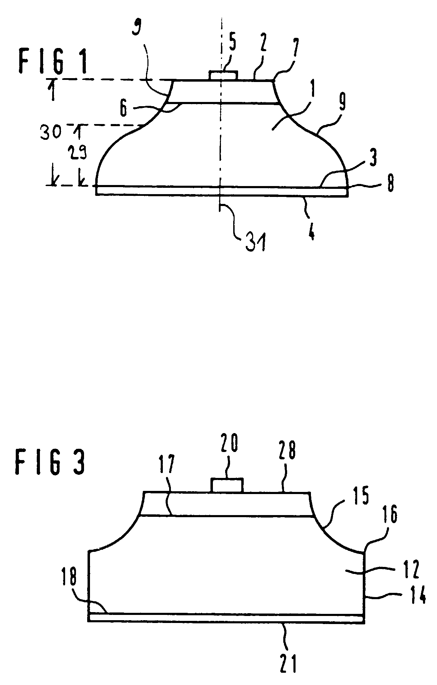

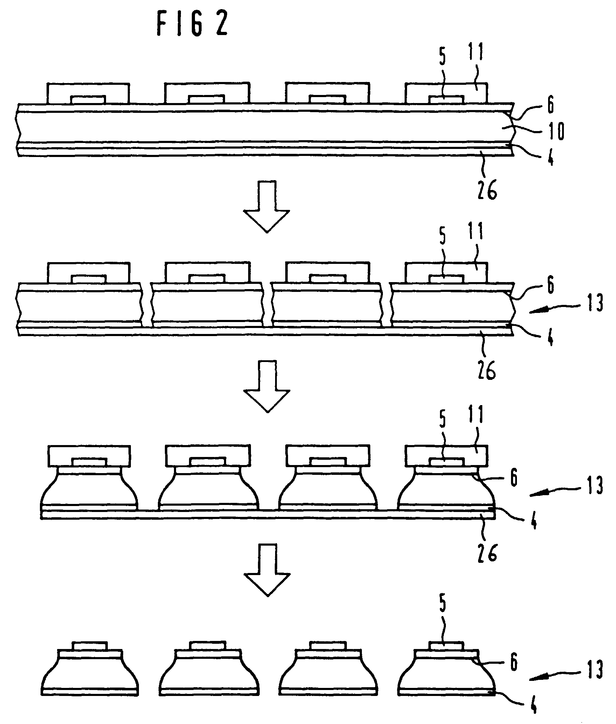

Die Erfindung wird anhand eines Ausführungsbeispieles in Verbindung mit den Figuren 1 und 2 näher erläutert. Es zeigen
Figur 1 eine schematische Darstellung eines Schnittes durch das Ausführungsbeispiel des erfindungsgemäßen Halbleiterkörpers und
Figur 2 eine schematische Darstellung des Ablaufs eines Verfahrens zum Herstellen einer Mehrzahl von Halbleiterkörpern gemäß Figur 1.

Der Halbleiterkörper 1 von Figur 1, beispielsweise bestehend aus GaAs oder einem anderen III/V-Halbleitermaterial, weist einen pn-Übergang 6, einen Vorderseitenkontakt 5, einen Rückseitenkontakt 4, eine Vorderseite 2, eine Rückseite 3 und eine gewölbte Seitenfläche 9 auf. Der pn-Übergang 6 ist beispielsweise mittels Si- und/oder Zn-Dotierung ausgebildet. Die Kontakte 4 und 5 sind beispielsweise aus Aluminium, Gold oder einem anderen geeigneten metallischen Werkstoff. Die gewölbte Seitenfläche 9 ist von außen gesehen benachbart der Vorderseite 2 konkav und benachbart der Rückseite 3 konvex. Der Halbleiterkörper 1 weist nur am Übergang von der Vorderseite 2 zur Seitenfläche 9 und am Übergang von der Rückseite 3 zur Seitenfläche 9 jeweils eine scharfe Kante 7, 8 auf. Der Rückseitenkontakt 4 kann reflektierend ausgebildet sein (beispielsweise poliert) und die gesamte Rückseite 3 oder nur Teilbereiche der Rückseite 3 bedecken. Der Vorderseitenkontakt 5 bedeckt nur einen kleinen Teil in der Mitte der Vorderseite 2. Um hinsichtlich der Verwendung als Lumineszendiode die Reflexionseigenschaften der Rückseite zu verbessern kann die Rückseite des Halbleiterkörpers vorteilhafterweise poliert oder mit einem reflexionssteigernden Material, beispielsweise Si₃N₄, beschichtet sein.

In dem Ausführungsbeispiel ist die gewölbte Seitenfläche 9 bis zu einer ersten Dicke 29 des Halbleiterkörpers 1 konvex, wobei die erste Dicke 29 größer ist als die Hälfte der Gesamtdicke 30 des Halbleiterkörpers 1. Ebenso kann die erste Dicke 29 aber auch kleiner oder gleich der Hälfte der Gesamtdicke 30 sein.

Eine Lumineszenzdiode mit einem derart geformten Halbleiterkörper 1 besitzt einen höheren externen Quantenwirkungsgrad als eine Lumineszenzdiode mit einem Halbleiterkörper 12 gemäß Figur 3. Von der gewölbten, einer Kalotte ähnlichen Seitenfläche 9 wird nämlich bedeutend weniger der vom pn-Übergang 6 in Richtung der Rückseite 3 des Halbleiterkörpers ausgesandten und dort reflektierten Lichtstrahlung in den Halbleiterkörper 1 total reflektiert als dies beim Halbleiterkörper 12 von Figur 3 der Fall ist. Der Grund dafür ist, daß im Vergleich zum Halbleiterkörper 12 von Figur 3 beim Halbleiterkörper 1 ein wesentlich größerer Teil der Oberfläche des Halbleiterkörpers 1 derart orientiert ist, daß die von der Rückseite 3 reflektierte Lichtstrahlung mit einem Winkel auf die Oberfläche des Halbleiterkörpers 1 trifft, der kleiner als der Grenzwinkel der Totalreflexion ist. Die Lichtverluste sind daher bei dem erfindungsgemäßen Halbleiterkörper 1 deutlich geringer.

Optional kann auch vorgesehen sein, daß der erfindungsgemäße Halbleiterkörper 1 nicht über die gesamte Seitenfläche 9, sondern nur ein Teilbereich oder mehrere Teilbereiche der Seitenfläche 9, z. B. einander in Bezug auf eine Mittelsenkrechte 31 gegenüberliegende Teilflächen der Seitenfläche 9, gewölbt sind. Das nachfolgend beschriebene Herstellungsverfahren muß dann beispielsweise durch geeignete Maskierung entsprechend angepaßt werden.

Mit dem in Figur 2 schematisch dargestellten Herstellverfahren können gleichzeitig eine Mehrzahl von Halbleiterkörpern 1 mit Rück- und Vorderseitenkontakt 4 bzw. 5 nach Figur 1 hergestellt werden. Dieses Verfahren weist folgende aufeinanderfolgende Verfahrensschritte auf:
a) Herstellen einer Halbleiterscheibe 10 mit ganzflächigem pn-Übergang 6, z. B. GaAs:Si/GaAs;
b) Dünnen der Halbleiterscheibe 10 auf die Enddicke, beispielsweise mittels Schleifen;
c) Aufbringen einer Mehrzahl von Vorderseitenkontakten 5 entsprechend einem vorgegebenen Raster und Aufbringen des Rückseitenkontaktes 4, beispielsweise jeweils mittels Aufdampfen;
d) Aufbringen einer Mehrzahl von beispielsweise aus Fotolack bestehenden Ätzmasken 11 entsprechend dem vorgegebenen Raster;
e) Befestigen der Halbleiterscheibe 10 auf einem Träger 26;
f) Vereinzeln der Halbleiterscheibe 10 entsprechend dem vorgegebenen Raster in eine Mehrzahl von Chips 13;
g) Isotropes Ätzen der Chips 13, im Falle einer Halbleiterscheibe 10 aus GaAs oder AlGaAs beispielsweise mit einer Ätzlösung aus Phosphorsäure, H₂O₂ und H₂O mit einem Mischungsverhältnis von 1:2:3 oder aus Schwefelsäure, H₂O₂ und H₂O mit einem Mischungsverhältnis von 3:1:1;
h) Entfernen der Ätzmasken 11;
i) Ablösen der Chips 13 vom Träger 26.

Anstelle einer Halbleiterscheibe 10 mit ganzflächigem pn-übergang 6 kann bei Schritt a) ebenso eine Halbleiterscheibe 10 mit entsprechend einem vorgegebenen Raster lokal eindiffundierten pn-Übergängen hergestellt werden. Als Dotierstoff eignet sich beispielsweise Zn. Die Schritte b) bis i) bleiben identisch.

Das erfindungsgemäße Verfahren hat gegenüber der oben beschriebenen und in Figur 4 schematich dargestellten Mesatechnik zwei Vorteile:
Erstens weist die Halbleiterscheibe bei den kritischen Prozeßschritten "Dünnen der Halbleiterscheibe auf die Enddicke" und "Vereinzeln der Halbleiterscheibe" überall dieselbe Dicke auf. Dadurch ist die Bruchfestigkeit deutlich höher als bei der konventionellen Mesatechnik nach Figur 4. Bei der konventionellen Mesatechnik ist, verursacht durch die in den Mesa-gräben herrschende geringe Dicke der Halbleiterscheibe 22, die Bruchrate bei den auf das Mesaätzen folgenden Verfahrensschritten sehr hoch.

Zweitens entfällt bei dem erfindungsgemäßen Verfahren ein Ätzschritt. Die Formgebung der Seitenflächen und die Beseitigung des beim Vereinzeln beschädigten Halbleitermaterials an den Schnittflächen erfolgt in einem einzigen Ätzschritt. Der Fertigungsaufwand ist daher bei dem erfindungsgemäßen Verfahren deutlich geringer als beim konventionellen Verfahren.

## Patentansprüche

1. Lumineszenzdiode mit einem Halbleiterkörper (1), der eine Vorderseite (2), eine Rückseite (3) und mindestens eine gewölbte Seitenfläche (9) aufweist, wobei die Fläche der Rückseite (3) größer ist als die Fläche der Vorderseite (2), **dadurch gekennzeichnet**, daß von außen betrachtet die gewölbte Seitenfläche (9) benachbart der Rückseite (3) konvex ist und benachbart der Vorderseite konkav ist, so daß ein großer Teil der Oberfläche des Halbleiterkörpers (1) derart orientiert ist, daß eine von der Rückseite (3) reflektierte Strahlung mit einem Winkel auf diese Oberfläche des Halbleiterkörpers trifft, der kleiner als der Grenzwinkel der Totalreflexion ist.

2. Lumineszenzdiode Anspruch 1, **dadurch gekennzeichnet**, daß die gewölbte Seitenfläche (9) bis zu einer ersten Dicke (29) des Halbleiterkörpers (1) konvex ist und daß die erste Dicke größer als die halbe Gesamtdicke (30) des Halbleiterkörpers (1) ist.

3. Lumineszenzdiode nach Anspruch 1 oder 2, **dadurch gekennzeichnet**, daß der Halbleiterkörper (1) eine einer Kalotte ähnliche Form aufweist.

4. Lumineszenzdiode nach einem der Ansprüche 1 bis 3, **dadurch gekennzeichnet**, daß eine Kunststoffumhüllung direkt auf den Halbleiterkörper (1) aufgebracht ist.

5. Lumineszenzdiode nach einem der Ansprüche 1 bis 4, **dadurch gekennzeichnet,** daß der Halbleiterkörper (1) aus III/V-Halbleitermaterial besteht.

6. Lumineszenzdiode nach Anspruch 5, **dadurch gekennzeichnet**, daß die Rückseite (3) des Halbleiterkörpers (1) reflektierend ausgebildet ist.

7. Lumineszenzdiode nach Anspruch 4 und 5 oder 6, **dadurch gekennzeichnet**, daß die Kunststoffumhüllung lichtdurchlässig ist.

8. Verfahren zur Herstellung einer Mehrzahl von Lumineszenzdioden mit einem Halbleiterkörper (1), der eine Vorderseite (2), eine Rückseite (3) und mindestens eine gewölbte Seitenfläche (9) aufweist, wobei die Fläche der Rückseite (3) größer ist als die Fläche der Vorderseite (2), **dadurch gekennzeichnet**, daß eine auf ein Trägermittel (26) aufgebrachte vorgefertigte Halbleiterscheibe (10) nach dem Aufbringen von mindestens zwei voneinander getrennten Ätzmasken (11) auf die dem Trägermittel (26) gegenüberliegende Seite der Halbleiterscheibe (10) in mindestens zwei Teile zertrennt wird, daß nachfolgend die noch auf dem Trägermittel (26) befestigten Teile isotrop geätzt werden, derart, daß eine Unterätzung der Ätzmasken (11) entsteht, so daß von außen betrachtet, die gewölbte Seitenfläche (9) benachbart der Rückseite (3) konvex und benachbart der Vorderseite (2) konkav ausgebildet wird und somit ein großer Teil der Oberfläche des Halbleiterkörpers (1) derart orientiert ist, daß im Betrieb der Lumineszenzdiode eine von der Rückseite reflektierte Strahlung mit einem Winkel auf diese Oberfläche des Halbleiterkörpers trifft, der kleiner als der Grenzwinkel der Totalreflexion ist.

9. Verfahren nach Anspruch 8, **gekennzeichnet durch** die Verfahrensschritte:
a) Herstellen der Halbleiterscheibe (10),
b) Aufbringen einer Mehrzahl von Vorderseitenkontakten (5) entsprechend einem vorgegebenen Raster;
c) Aufbringen des Rückseitenkontaktes (4) auf die Halbleiterscheibe (10),
d) Aufbringen der Mehrzahl von voneinander getrennten Ätzmasken (11), derart, daß die Vorderseitenkontakte (5) und ein Teil der Vorderseite der Halbleiterscheibe (19) abgedeckt sind,
e) Befestigen der Halbleiterscheibe (10) auf einem Trägermittel (26),
f) Vereinzeln der Halbleiterscheibe (10) zwischen den Ätzmasken (11) in Chips (13),
g) isotropes Ätzen der Chips (13), derart, daß die Ätzmasken (11) unterätzt werden,
h) Entfernen der Ätzmasken (11),
i) Ablösen der Chips (13) vom Träger (26).

## Claims

1. Light-emitting diode having a semiconductor body (1), which has a front side (2), a rear side (3) and at least one curved side surface (9), the area of the rear side (3) being greater than the area of the front side (2), characterized in that, viewed from outside, the curved side surface (9) is convex adjacent to the rear side (3) and is concave adjacent to the front side, with the result that a large part of the surface of the semiconductor body (1) is oriented in such a way that the radiation reflected from the rear side (3) impinges on the surface of the semiconductor body at an angle which is less than the critical angle of total reflection.

2. Light-emitting diode according to Claim 1, characterized in that the curved side surface (9) is convex up to a first thickness (29) of the semiconductor body (1), and in that the first thickness is greater than half the total thickness (30) of the semiconductor body (1).

3. Light-emitting diode according to Claim 1 or 2, characterized in that the semiconductor body (1) has a shape similar to a calotte.

4. Light-emitting diode according to one of Claims 1 to 3, characterized in that a plastic encapsulation is applied directly to the semiconductor body (1).

5. Light-emitting diode according to one of Claims 1 to 4, characterized in that the semiconductor body (1) comprises III/V semiconductor material.

6. Light-emitting diode according to Claim 5, characterized in that the rear side (3) of the semiconductor body (1) is designed to reflective.

7. Light-emitting diode according to Claim 4 and 5 or 6, characterized in that the plastic encapsulation is transparent to light.

8. Method for producing a plurality of light-emitting diodes having a semiconductor body (1), which has a front side (2), a rear side (3) and at least one curved side surface (9), the area of the rear side (3) being greater than the area of the front side (2) characterized in that a prefabricated semiconductor wafer (10) applied to a carrier means (26) is severed into at least two parts after the application of at least two mutually separated etching masks (11) to that side of the semiconductor wafer (10) which is opposite to the carrier means (26), in that those parts still secured on the carrier means (26) are subsequently isotropically etched in such a way that an undercut of the etching masks (11) is produced with the result that, viewed from outside, the curved side surface (9) is designed to be convex adjacent to the rear side (3) and concave adjacent to the front side (2) and, consequently, a large part of the surface of the semiconductor body (1) is oriented in such a way that, during operation of the light-emitting diode, the radiation reflected from the rear side impinges on the surface of the semiconductor body at an angle which is less than the critical angle of total reflection.

9. Method according to Claim 8, characterized by the method steps:
a) production of the semiconductor wafer (10),
b) application of a plurality of front side contacts (5) in accordance with a predetermined grid pattern;
c) application of the rear side contact (4) to the semiconductor wafer (10),
d) application of the plurality of mutually separated etching masks (11), in such a way that the front side contacts (5) and part of the front side of the semiconductor wafer (19) are covered,
e) securing of the semiconductor wafer (10) on a carrier means (26),
f) separation of the semiconductor wafer (10) between the etching masks (11) into chips (13),
g) isotropic etching of the chips (13) in such a way that the etching masks (11) are undercut,
h) removal of the etching masks (11),
i) detachment of the chips (13) from the carrier (26).

## Revendications

1. Diode électroluminescente ayant un corps semi-conducteur (1) compcrtant une face avant (2), une face arrière (3) et au moins une surface latérale incurvée (9), la surface de la face arrière (3) étant plus grande que la surface de la face avant (2), caractérisée par le fait que, vue de l'extérieur, la surface latérale incurvée (9) est convexe au voisinage de la face arrière (3) et concave au voisinage de la face avant, de sorte qu'une grande partie de la surface du corps semi-conducteur (1) est orientée pour qu'un rayonnement réfléchi par la face arrière (3) arrive sur cette surface du corps semi-conducteur selon un angle qui est inférieur à l'angle limite de la réflexion totale.

2. Diode électroluminescente selon la revendication 1, caractérisée par le fait que la surface latérale incurvée (9) est convexe jusqu'à une première épaisseur (29) du corps semi-conducteur (1), et que la première épaisseur est plus grande que la moitié de l'épaisseur totale (30) du corps semi-conducteur (1).

3. Diode électroluminescente selon la revendication 1 ou 2, caractérisée par le fait que le corps semi-conducteur (1) a une forme analogue à une calotte.

4. Diode électroluminescente selon l'une quelconque des revendications 1 à 3, caractérisée par le fait qu'un revêtement en matière plastique est appliqué directement sur le corps semi-conducteur (1).

5. Diode électroluminescente selon l'une quelconque des revendications 1 à 4, caractérisée par le fait que le corps semi-conducteur (1) est constitué de matériau semi-conducteur III/V.

6. Diode électroluminescente selon la revendication 5, caractérisée par le fait que la face arrière (3) du corps semi-conducteur (1) est réfléchissante.

7. Diode électroluminescente selon l'une des revendications 4 et 5 ou 6, caractérisée par le fait que le revêtement en matière plastique est translucide.

8. Procédé de fabrication d'une pluralité de diodes électroluminescentes ayant un corps semi-conducteur (1) comportant une face avant (2), une face arrière (3) et au moins une surface latérale incurvée (9), la surface de la face arrière (3) étant plus grande que la surface de la face avant (2), caractérisé par le fait qu'une tranche semi-conductrice (10) préfabriquée fixée sur un moyen de support (26) est divisée en au moins deux parties après le dépôt d'au moins deux masques de gravure (11) séparés l'un de l'autre sur la face de la tranche semi-conductrice (10) opposée au moyen de support (26), que les parties encore fixées sur le moyen de support (26) sont ensuite gravées de façon isotrope de façon à obtenir une gravure sous les masques de gravure (11), de sorte que, vue de l'extérieur, la surface latérale incurvée (9) soit convexe au voisinage de la face arrière (3) et concave au voisinage de la face avant (2), et qu'une grande partie de la surface du corps semi-conducteur (1) soit ainsi orientée de telle sorte qu'au cours du fonctionnement de la diode électroluminescente un rayonnement réfléchi par la face arrière arrive sur cette surface du corps semi-conducteur suivant un angle qui est inférieur à l'angle limite de la réflexion totale.

9. Procédé selon la revendication 8, caractérisé par les phases de procédé suivantes :
a) fabrication de la tranche semi-conductrice (10) ;
b) dépôt d'une pluralité de contacts (5) de face avant selon une trame prédéfinie ;
c) dépôt du contact (4) de face arrière sur la tranche semi-conductrice (10) ;
d) dépôt de la pluralité de masques de gravure (11) séparés les uns des autres de telle sorte que les contacts (5) de face avant et une partie de la face avant de la tranche semi-conductrice soient recouverts ;
e) fixation de la tranche semi-conductrice (10) sur un moyen de support (26) ;
f) individualisation de la tranche semi-conductrice (10) en chips (13) entre les masques de gravure (11) ;
g) gravure isotrope des chips (13) de telle sorte qu'une gravure soit obtenue sous les masques de gravure (11) ;
h) élimination des masques de gravure (11) ;
i) séparation des chips (13) du support (26).
